(19) Europäisches Patentamt
European Patent Office
Office européen des brevets

(11) EP 2 731 269 B1

(12) EUROPÄISCHE PATENTSCHRIFT

(45) Veröffentlichungstag und Bekanntmachung des Hinweises auf die Patenterteilung:
**14.10.2015 Patentblatt 2015/42**

(51) Int Cl.:
*H03K 17/689* $^{(2006.01)}$    *H01L 27/02* $^{(2006.01)}$
*H03K 5/003* $^{(2006.01)}$

(21) Anmeldenummer: **13178916.6**

(22) Anmeldetag: **01.08.2013**

(54) **Ansteuerschaltung mit Übertragungsschaltung und Verfahren zum Betrieb**

Actuation switch with transmission circuit and method for operating

Circuit de commande avec circuit de transmission et procédé de fonctionnement

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.11.2012 DE 102012220213**

(43) Veröffentlichungstag der Anmeldung:
**14.05.2014 Patentblatt 2014/20**

(73) Patentinhaber: **SEMIKRON Elektronik GmbH & Co. KG**
**90431 Nürnberg (DE)**

(72) Erfinder:
• **Herzer, Reinhard**
**98693 Ilmenau (DE)**
• **Roßberg, Matthias**
**98693 Ilmenau (DE)**
• **Vogler, Bastian**
**90763 Fürth (DE)**

(56) Entgegenhaltungen:
**EP-A2- 1 887 698      EP-A2- 2 385 629**
**US-A1- 2008 231 340**

# EP 2 731 269 B1

**Beschreibung**

Die Erfindung beschreibt eine Ansteuerschaltung mit Übertragungsschaltung zur Übertragung eines Signals über eine Potentialbarriere hinweg, wie sie in Treiberschaltungen von Leistungshalbleitermodulen Verwendung findet.

Der Stand der Technik wird insbesondere gebildet durch DE 10 2010 018 997 A1. Diese offenbart eine Ansteuerschaltung mit Übertragungsschaltung zur Übertragung eines Signals von einer Primärseite mit erstem Grundpotential zu mindestens einer Sekundärseite mit jeweiligem zweitem Grundpotential mit einem Übertrager mit kapazitiver Kopplung zwischen der Primär- und der Sekundärseite. Hierbei weist der Übertrager zwei Zweige, einen ON- Übertragungszweig und einen OFF-Übertragungszweig auf, die ihrerseits je einen ersten und einen zweiten Teilzweig aufweisen, wobei die kapazitive Kopplung zwischen Primär- und Sekundärseite bei jedem Teilzweig durch Hochvoltkondensatoren ausgeführt wird. Gemäß dem erfindungsgemäßen Verfahren erzeugt in jedem Übertragungszweig das dortige Signal einen Stromfluss durch einen ersten HV- Kondensator eines ersten Teilzweiges und einen inversen Stromfluss durch einen zweiten HV- Kondensator eines zweiten Teilzweiges. Dieser jeweilige Stromfluss wird auf der Sekundärseite detektiert und einer beiden Teilzweigen gemeinsamen Auswerteschaltung zugeführt, die das primärseitige Eingangssignal sekundärseitig rekonstruiert.

Der Erfindung liegt die Aufgabe zugrunde, die bekannte Übertragungsschaltung derart weiterzubilden, dass Signal auch über Potentialbarrieren hinweg übertragen werden können, bei denen die Spannungsdifferenz zwischen einer ersten Potentialseite und einer zweiten Potentialseite höher ist als die Spannungsfestigkeit eines einzelnen Hochvoltkondensators sowie ein Verfahren zum Betrieb einer derartigen Übertragungsschaltung anzugeben.

Diese Aufgabe wird erfindungsgemäß gelöst durch ein leistungselektronisches System mit den Merkmalen des Anspruchs 1 und durch ein Verfahren mit den Merkmalen des Anspruchs 10.

Bevorzugte Ausführungsformen sind in den jeweiligen abhängigen Ansprüchen beschrieben.

Die Erfindung umfasste eine Ansteuerschaltung mit Übertragungsschaltung zur Übertragung eines Signals über eine Potentialbarriere hinweg, von einer ersten Potentialseite mit erstem Grundpotential zu einer zweiten Potentialseite mit zweitem Grundpotential, mit einer kapazitiv wirkenden Übertragungseinrichtung mit kapazitiver Kopplung zwischen der ersten und der zweiten Potentialseite, wobei die Übertragungseinrichtung genau einen oder zwei Zweige, somit nur einen ON-Übertragungszweig oder einen ON- Übertragungszweig und einen OFF-Übertragungszweig aufweist, die ihrerseits jeweils einen ersten und einen zweiten Teilzweig aufweisen, wobei die kapazitive Kopplung zwischen erster und zweiter Potentialseite bei jedem Teilzweig durch eine Reihenschaltung einer Mehrzahl von ersten und zweiten Hochvoltkondensatoren ausgebildet ist, die wiederum jeweils eine Reihenschaltung mit einem zugeordneten Kondensator auf der zweiten Potentialseite bilden, wobei innerhalb des jeweiligen Übertragungszweiges das Signal direkt an einem ersten Teilzweig und über einen zweiten Inverter an einem zweiten Teilzweig anliegt und wobei bei zwei Zweigen ein Signal am Eingang direkt an dem ON-Übertragungszweig und über einen ersten Inverter am OFF- Übertragungszweig anliegt.

Es entspricht der Erfindung, wenn parallel zu den ersten und zweiten Hochvoltkondensatoren eines Zweiges ein weiterer kapazitiver Spannungsteiler mit der gleichen Anzahl von Symmetrierungskondensatoren wie erste und zweite Hochvoltkondensatoren, wobei jedes der Zwischenpotentiale von Symmetrierungs- und zugeordneter Hochvoltkondensatoren mittels einer Zenerdioden-Ausgleichsschaltung verbunden sind.

Weiterhin erweist es sich als vorteilhaft, wenn die Zenerdioden-Ausgleichsschaltung ausgebildet ist als je zwei Reichenschaltungen zweier Zenerdioden, die mit Ihren Anoden oder ihren Kathoden miteinander verbunden sind und deren Kathoden bzw.
Anoden einerseits mit dem jeweiligen Zwischenpotential der Symmetrierungskondensatoren und andererseits mit dem zugeordneten Zwischenpotential der Hochvoltkondensatoren verbunden sind.

Es kann auch vorteilhaft sein, wenn die Reihenschaltung der Symmetrierungskondensatoren mit dem Versorgungspotentialen der ersten und zweiten Potentialseite verbunden sind.

Insbesondere ist es vorteilhaft, wenn zu jedem Symmetrierungskondensator eine Spannungsbegrenzungsschaltung parallel geschaltet ist.

Zudem kann es vorteilhaft sein, wenn die Spannungsbegrenzungsschaltung mit einem oberen und einem unteren Anschluss, aus einer Reihenschaltung von weiteren Zenerdioden und einem parallel geschalteten Spannungsbegrenzungstransistor, dessen Source mit dem unteren Anschluss, dessen Drain mit dem oberen Anschluss der Spannungsbegrenzungsschaltung und dessen Gate einerseits mit der Kathode der ersten Zenerdiode der Reihenschaltung und andererseits über einen Widerstand, mit der Anode der ersten Zenerdiode der Reihenschaltung verbunden ist.

Grundsätzlich, insbesondere wenn die Gesamtpotentialdifferenz von einer ersten Potentialseite mit erstem Grundpotential zu einer zweiten Potentialseite mit zweitem Grundpotential größer ist als die Spannungsfestigkeit der Hochvoltkondensatoren und wenn gelichzeitig oder alternativ diese Gesamtpotentialdifferenz größer ist als der Isolationsfestigkeit der zweiten Potentialseite zum Substrat, erweist es sich für die Ansteuerschaltung als vorteilhaft, wenn die jeweiligen Komponenten auf einer Mehrzahl von voneinander elektrisch isolierten Substraten jeweils monolithisch integriert angeordnet sind. Hierbei ist es weiterhin vorteilhaft, wenn der Mittelpunkt einer Zenerdioden-Ausgleichsschaltung mit dem Grundpotential elektrisch leitend verbunden ist.

Dies kann vorteilhafte ausgestaltet sein indem die jeweiligen Komponenten auf zwei Substraten angeordnet sind und hierbei die Komponenten der ersten Potentialseite auf dem ersten Substrat angeordnet sind und diejenigen der zweiten Potentialseite auf dem zweiten Substrat angeordnet sind. Alternativ können die jeweiligen Komponenten auf mehr als zwei Substraten angeordnet sein und hierbei die Komponenten der ersten Potentialseite auf einem ersten Substrat angeordnet sein und diejenigen der zweiten Potentialseite auf einem zweiten Substrat angeordnet sein, sowie Hochvoltkondensatoren und zugeordnete Spannungsbegrenzungsschaltungen auf jeweils eigenen weiteren Substraten angeordnet sein. Hierbei ist es besonders bevorzugt, wenn die jeweiligen Substrate innerhalb eines Multi-Chip-Moduls angeordnet sind.

Das erfindungsgemäße Verfahren umfasst ein Eingangssignal an einer ersten Potentialseite, das am Eingang der Übertragungseinrichtung direkt an einen ON-Übertragungszweig angelegt wird, wobei in jedem Übertragungszweig das dortige Signal einen Stromfluss durch erste Hochvoltkondensator eines ersten Teilzweiges und einen inversen Stromfluss durch zweite Hochvoltkondensator eines zweiten Teilzweiges erzeugt, dieser jeweilige Stromfluss auf der Sekundärseite detektiert und einer beiden Teilzweigen gemeinsamen Auswerteschaltung zugeführt wird, die das Eingangssignal auf der zweiten Potentialseite rekonstruiert und wobei eine Spannungsbegrenzungsschaltung in Kombination mit einer Zenerdioden-Ausgleichsschaltung die über den jeweiligen Hochvoltkondensatoren abfallende Teilspannung begrenzt.

Es kann hierbei auch vorteilhaft sein, wenn ein primärseitiges Eingangssignal am Eingang der Übertragungseinrichtung direkt an einen ON- Übertragungszweig und invertiert an einen OFF- Übertragungszweig angelegt wird.

Es versteht sich, dass die verschiedenen Ausgestaltungen der Erfindung einzeln oder in beliebigen Kombinationen realisiert sein können, um Verbesserungen zu erreichen. Insbesondere sind die vorstehend genannten und erläuterten Merkmale nicht nur in den angegebenen Kombinationen, sondern auch in anderen Kombinationen oder in Alleinstellung einsetzbar, ohne den Rahmen der vorliegenden Erfindung zu verlassen.

Weitere Erläuterung der Erfindung vorteilhafte Einzelheiten und Merkmale ergeben sich aus der nachfolgenden Beschreibung der in den Fig. 1 bis 7 dargestellten Ausführungsbeispiele der erfindungsgemäßen Leistungshalbleiterschaltung oder von Teilen hiervon.

Figur 1 zeigt ein Blockschaltbild mit einer monolithisch integrierten Ansteuerschaltung.

Figur 2 zeigt ein Blockschaltbild einer Ausführungsform einer erfindungsgemäßen monolithisch integrierten Ansteuerschaltung.

Figur 3 zeigt eine Grundschaltung einer Übertragungseinrichtung mit zwei Zweigen von einer ersten Potentialseite zu einer zweiten.

Figur 4 zeigt eine Grundschaltung einer Übertragungseinrichtung mit nur einem Zweig von einer zweiten Potentialseite zu einer ersten.

Figur 5 zeigt Simulationsergebnisse des erfindungsgemäßen Verfahrens.

Figur 6 zeigt eine Grundschaltung einer Übertragungseinrichtung von einer ersten Potentialseite zu einer zweiten mit aktiver Spannungsbegrenzung der Zwischenpotentiale.

Figur 7 zeigt eine weitere Ausführungsform einer Übertragungseinrichtung.

Grundsätzlich sind alle wesentlichen Teile der Übertragungseinrichtung für ein oder zwei Zweige von einer ersten Potentialseite zu einer zweiten Potentialseite identisch. In den Ausführungsbeispielen sind somit alle Aussagen, die sich auf die Übertragung von einer Potentialseite zu einer zweiten, also beispielhaft der Primärseite zur Sekundärseite in gleicher Weise gleichbedeutend auch für die umgekehrte Richtung, also von der Sekundärseite zur Primärseite, auch wenn die jeweiligen Beispiele unterschiedliche Ausführungsformen zeigen.

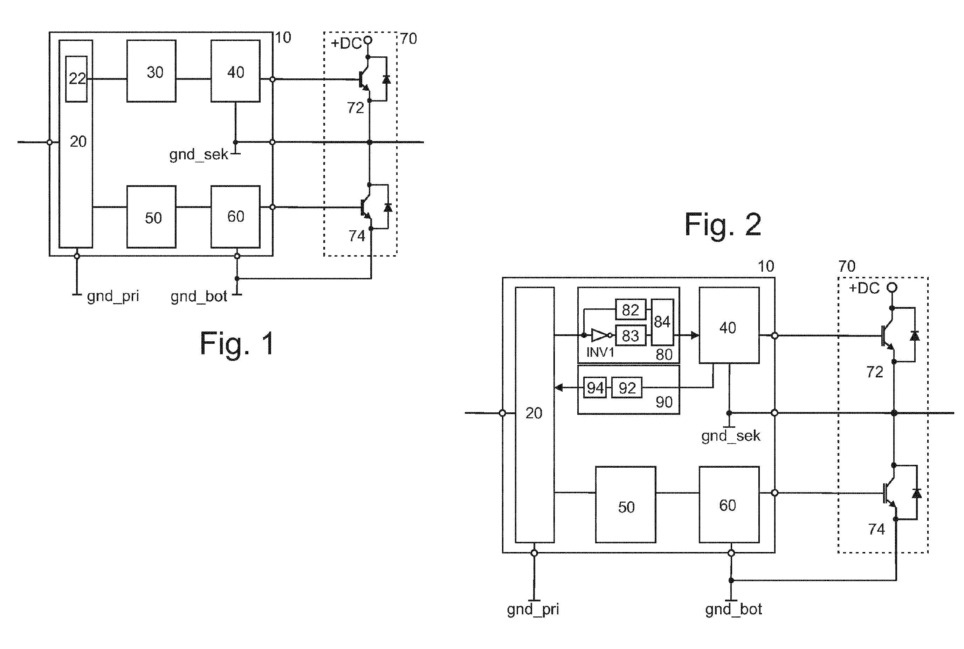

Figur 1 zeigt zur Erläuterung der Erfindung ein Blockschaltbild mit einer monolithisch integrierten Ansteuerschaltung 10 nach dem Stand der Technik, sowie eine hierdurch ansteuerbare Halbbrückenschaltung 70. Diese Halbbrückenschaltung 70 weist einen TOP- 72 und einen BOT-Leistungsschalter 74 auf, die hier jeweils als ein IGBT mit antiparallel geschalteter Diode ausgebildet sind. Der BOT- Leistungsschalter 74 liegt auf dem Bezugspotential gnd_bot der BOT-Sekundärseite, welches beispielhaft bei Applikationen mit kleinen Leitungsinduktivitäten nahezu gleich dem Bezugspotential gnd_pri der Primärseite der Ansteuerschaltung 10 ist.

Die Ansteuerschaltung 10 selbst weist eine Ansteuerlogik 20 mit einer Pulserzeugungsschaltung 22, einen Vorwärts-Übertrager 30, also eine Übertragungseinrichtung von der Primär- zur Sekundärseite, mit nachgeschalteter TOP-Sekundärseite 40 sowie einen zweiten Vorwärts-Übertrager 50 mit nachgeschalteter BOT-Sekundärseite 60 auf, wobei die jeweiligen Vorwärts-Übertrager als kapazitive Übertrager gemäß dem Stand der Technik ausgebildet sind.

Figur 2 zeigt ein Blockschaltbild mit relevanten Teilen einer erfindungsgemäßen monolithisch integrierten Ansteuerschaltung mit einem Vorwärts-Übertrager 80, der einen ON-Übertragungszweig 82, einen grundsätzlich identischen OFF-Übertragungszweig 83, und eine diesen Übertragungszweigen nachgeschalteten gemeinsamen Signalauswerteschaltung 84 aufweist. Das zu übertragende Signal wird an den ON-Übertragungszweig 82 direkt und an den OFF-Übertragungszweig 83 mittels eines vorgeschalteten ersten Inverter INV1 angelegt. Der Vorwärts-Übertrager überträgt somit innerhalb der Ansteuerschaltung das Signal von der Primärseite mit erstem Potential gnd_pri auf die Sekundärseite mit zweitem Potential gnd_sek.

Ebenso dargestellt ist ein Rückwärts-Übertrager 90, also eine Übertragungseinrichtung von der Sekundär- zur Primärseite, wobei der Rückwärts-Übertrager grundsätzlich komplementär zum Vorwärts-Übertrager aufgebaut ist. Der Rückwärts-Übertrager dient beispielhaft der Übertragung von Sensor- oder Statussignalen von der Sekundär- zur Primärseite. Der Rückwärts-Übertrager 90 besteht analog zum Vorwärts-Übertrager 80 aus einem ON- Übertragungszweig 92 weist allerdings keinen OFF-Übertragungszweig 93 auf. Ebenso weist er eine in manchen Ausgestaltungen nicht zwingend notwendige nachgeschaltete Signalauswerteschaltung 94 auf. Zur primärseitigen Auswertung mancher auf der TOP-Sekundärseite erzeugten Signale ist es nicht notwendig dieses Signal in vollständiger Länge zur Primärseite zu übertragen, es kann hier ein kurzer Übertragungspuls oder eine repetitive Folge kurzer Übertragungspulse ausreichend sein. Deshalb wurde hier auf den OFF-Übertragungszweig verzichtet.

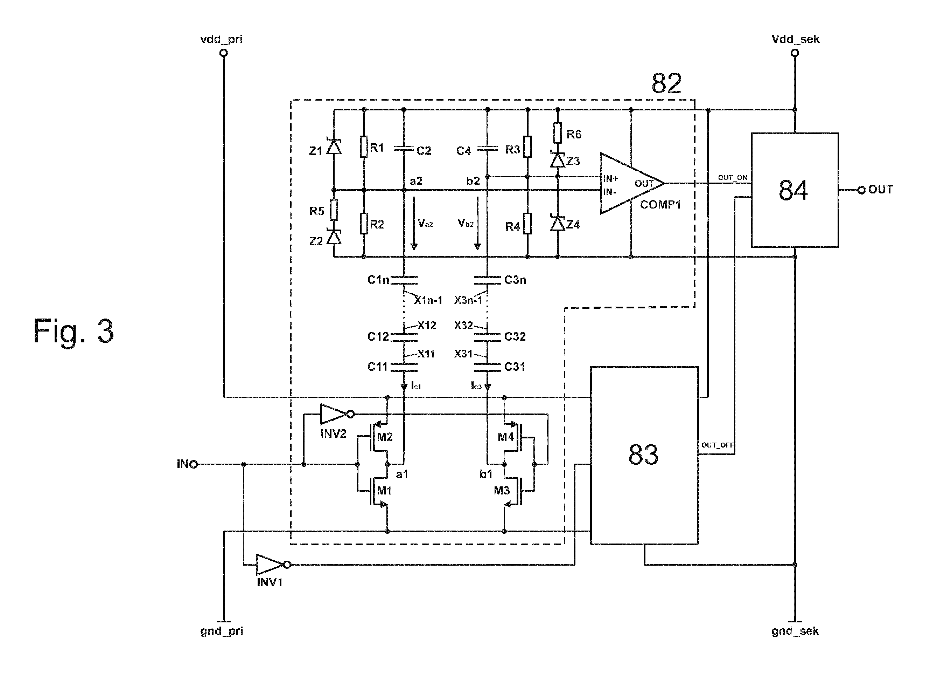

Figur 3 zeigt eine Grundschaltung eines Vorwärts- Übertragers 80, bestehend aus einem ersten Inverter INV1, einem ON-Übertragungszweig 82 und einem identischen OFF-Übertragungszweig 83 sowie einer Signalauswerteschaltung 84. Da beide Übertragungszweige identisch aufgebaut sind, ist ausschließlich der ON-Übertragungszweig im Detail dargestellt, wobei die folgenden allgemeinen Aussagen für beide Übertragungszweige gelten.

Der jeweilige Übertragungszweig besteht aus einem primärseitigen Schaltungsteil, einem sekundärseitigen Schaltungsteil und jeweils n in Reihe geschalteten Hochvoltkondensatoren C1 x, C3x, mit x = 1...n hier und im Folgenden auch als HV-Kondensatoren bezeichnet, die die beiden Schaltungsteile verbinden. Der primärseitige Schaltungsteil weist zwei Brückenschaltungen M1, M2 und M3, M4 auf, mit jeweils einem Transistor M1, M3 vom n-Kanal-Typ und jeweils einem M2, M4 vom p-Kanal-Typ. Die Source-Anschlüsse der n-Kanal Transistoren (M1, M3) sind an das primärseitige Bezugspotential gnd_pri und die Source-Anschlüsse der p-Kanal Transistoren M2, M4 sind an die primärseitige Versorgungsspannung vdd_pri angeschlossen. Die Gate-Anschlüsse der Transistoren der ersten Brückenschaltung M1, M2 sind direkt mit dem Eingang IN des Vorwärts-Übertragers 80 verbunden. Die Gate-Anschlüsse der Transistoren der zweiten Brückenschaltung M3, M4 sind mit dem Ausgang eines zweiten Inverters INV2 verbunden, dessen Eingang mit dem Eingang IN des Vorwärts-Übertragers 80 verbunden ist. Die Reihenschaltung der HV-Kondensatoren C1x ist einerseits mit dem Ausgang a1 der ersten Brückenschaltung M1, M2 und andererseits einem ersten sekundärseitigen Knotenpunkt a2 verbunden. Die erste Brückenschaltung M1, M2, die Reihenschaltung der HV-Kondensatoren C1x und der erste sekundärseitige Knotenpunkt a2 bilden mit dessen Beschaltung den ersten Teilzweig aus. Der zweite Teilzweig ist grundsätzlich identisch aufgebaut und unterscheidet sich vom ersten nur in der Beschaltung des zweiten sekundärseitigen Knotenpunktes b2.

Die Beschaltung der sekundärseitigen Knotenpunkte a2, b2 ist folgendermaßen ausgebildet und mit einem ersten Komparator COMP1 verbunden. Der erste Anschluss weiterer Kondensatoren C2, C4 ist mit einem zugeordneten Knotenpunkt a2, b2 verbunden, während der zweite Anschluss mit der Versorgungsspannung der Sekundärseite vdd_hs verbunden ist. Der sekundärseitige Knotenpunkt a2 ist an den invertierenden Eingang IN- des ersten Komparators COMP1 angeschlossen. Der sekundärseitige Knotenpunkt b2 ist an den nicht invertierenden Eingang IN+ des ersten Komparators COMP1 angeschlossen. Die Widerstände R1, R2 bzw. R3, R4 bilden jeweils einen Spannungsteiler zwischen der Versorgungsspannung der Sekundärseite vdd_hs und dem Bezugspotential der Sekundärseite gnd_hs, deren Mittelpunkt mit dem zugeordneten Knotenpunkt a2, b2 verbunden ist. Parallel zu den Spannungsteilern ist eine Reihenschaltung zweier Zenerdioden Z1, Z2 bzw. Z3, Z4 und eines Widerstandes R5 bzw. R6 geschaltet und der Mittelpunkt dieser jeweiligen Schaltung ist wiederum mit dem Knotenpunkt verbunden. Der Ausgang OUT_ON des ersten Komparators COMP1 ist gleichzeitig der Ausgang des entsprechenden ON-Übertragungszweigs 82 und ist mit dem zugeordneten Eingang der Signalauswerteschaltung 84 verbunden.

Das Verhältnis der Kapazitäten der Reihenschaltung der HV-Kondensatoren C1x, C3x zu denjenigen der zugeordneten weiteren Kondensatoren C2, C4 der sekundärseitigen Beschaltung der jeweiligen Knotenpunkte a2, b2 wird vorteilhaft derart gewählt, dass sich deren Kapazitäten verhalten wie

C1ges/C2 = C3ges / C4 « 1, wobei sich die Gesamtkapazität C1ges, C3ges der jeweiligen Reihenschaltung wie folgt ergibt:

$$C1ges = (C11*C12*\ldots*C1n) / (C11+C12+\ldots+C1n) \text{ bzw.}$$

$$C3ges = (C31*C32*...*C3n) / (C31+C32+...+C3n).$$

Die Summe der Durchbruchspannungen der in Reihe geschalteten HV-Kondensatoren C1x, C3x ist erfindungsgemäß größer als die maximal auftretende Potentialdifferenz zwischen der sekundärseitigen Versorgungsspannung vdd_sek und dem primärseitigen Bezugspotential gnd_pri. Solange im Rahmen des erfindungsgemäßen Übertragungsverfahrens keine Spannungstransienten an den sekundärseitigen Knotenpunkten a2, b2 also zwischen primär- und sekundärseitigen Bezugspotentialen und Versorgungsspannungen auftreten befindet sich der Übertragungszweig im stationären Zustand. Die Potentiale an den sekundärseitigen Knotenpunkten a2, b2, bezogen auf das sekundärseitige Bezugspotential gnd_sek, werden dann durch die Spannungsteiler R1, R2 bzw. R3, R4 und durch die Höhe der sekundärseitigen Versorgungsspannung vdd_sek bestimmt. Die Spannungsteiler sind derart ausgebildet, dass im stationären Gleichgewicht das Potential am ersten sekundärseitigen Knotenpunkt a2 geringfügig höher, beispielhaft 200mV, als das Potential am zweiten sekundärseitigen Knotenpunkt b2 ist. Damit wird gewährleistet, dass der erste Komparator COMP1 im stationären Gleichgewicht derart angesteuert wird, dass sein Ausgang OUT_ON auf einem LOW-Zustand "AUS" verharrt.

Weiterhin sind die Spannungsteiler R1, R2 und R3, R4 derart gestaltet, dass die Potentiale an den sekundärseitigen Knotenpunkten a2, b2 etwa der Hälfte der sekundärseitigen Versorgungsspannung vdd_sek entsprechen. Die weiteren Bauelemente Z1, R5, Z2, bzw. Z3, Z4, R6 der Beschaltung der sekundärseitigen Knotenpunkte a2, b2 begrenzen einen möglichen Verriss der Potentiale bei auftretenden Spannungstransienten an diesen Knotenpunkten a2, b2 jeweils auf einen oberen und einen unteren Wert. Die Zenerspannung der Zenerdioden Z1..Z4 ist dabei jeweils so gewählt, dass die Potentiale an den sekundärseitigen Knotenpunkten a2, b2 nur Werte innerhalb eines bestimmten Spannungsfensters einnehmen können

Bei zeitlich schneller positiver Spannungsänderung zwischen primärseitigem und sekundärseitigem Bezugspotential, verursacht durch Schaltvorgänge der Leistungshalbbrücke, teilt sich die Spannung gemäß der kapazitiven Spannungsteilerregel über den in Reihe geschalteten Kondensatoren des jeweiligen Übertragungszweiges auf. An den Knoten X1x, mit x = 1...n-1 werden n-1 Zwischenpotentiale erzeugt. Bei geeigneter Dimensionierung der Kondensatoren C1x und C2 bzw. C3x und C4 teilt sich die ändernde Spannung annähernd gleichmäßig über den Knoten X1x und a2 bzw. X3x und b2 auf, so dass über jedem Kondensator eine Spannung abfällt, die etwa dem n-ten Teil der gerade anliegenden Spannung zwischen vdd_sek und gnd_pri entspricht. Die durch die Kondensatoren erzeugte Teilung der Spannung bleibt auch nach dem Abklingen der zeitlichen Spannungsänderung erhalten, da die Kondensatoren die gespeicherte Ladung halten.

Die erfindungsgemäße Signalübertragung durch Ladungsverschiebung an den HV-Kondensatoren C1x, C3x über einen Übertragungszweig erfolgt unabhängig davon ob das Bezugspotential gnd_sek der Sekundärseite statisch höher, gleich oder niedriger ist als das Bezugspotential gnd_pri der Primärseite.

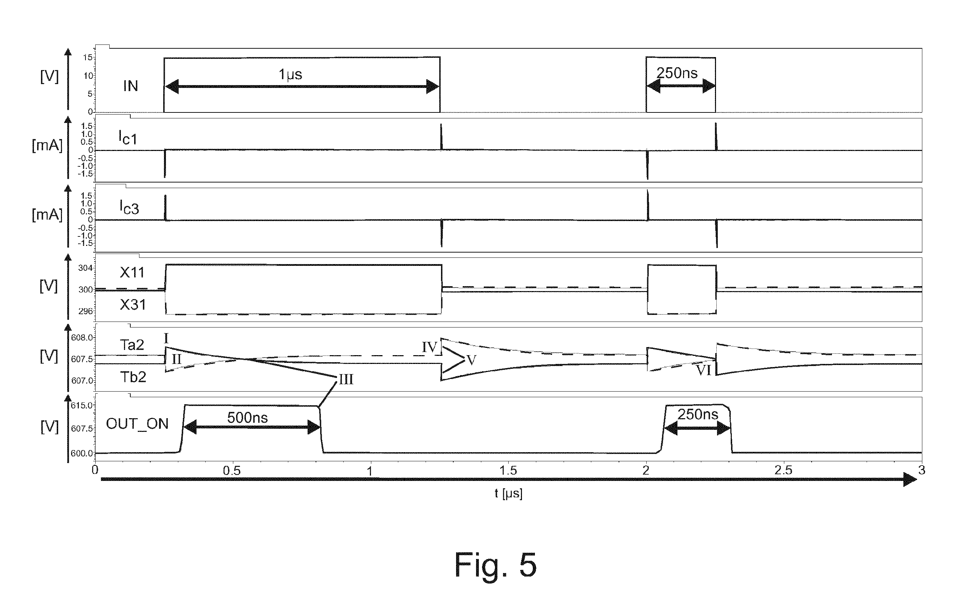

Nach dem erfindungsgemäßen Verfahren wird ein am Eingang IN des Vorwärts-Übertragers 82 anliegendes Eingangssignal direkt an den Eingang des ON-Übertragungszweigs 82 und invertiert an den Eingang des OFF-Übertragungszweigs 83 angelegt. Aufgrund der identischen Ausführung des ON- und des OFF-Übertragungszweigs 82, 83 wird im Folgenden nur die Funktion des ON-Übertragungszweigs detailliert beschrieben. Erläuternd hierzu zeigt Fig. 5 zugehörige Simulationsergebnisse für die Ausführungsform mit zwei in Reihe geschalteten HV-Kondensatoren, d.h. n=2, bei einem positiven Bezugspotential der TOP-Sekundärseite gnd_sek=600V. Das Bezugspotential der Primärseite gnd_pri liegt dabei beispielhaft auf Erdpotential (0V). Als Signalform wurden Rechtecksignale gewählt. Dargestellt sind jeweils das Signal am Eingang IN, die Potentialverläufe an den Knotenpunkten X11, X31 und a2, b2 und das Signal am Ausgang OUT_ON des ON-Übertragungszweigs. Das Gesagte gilt für den OFF-Übertragungszweig in gleicher Weise mit vertauschter positiver und negativer Eingangssignalflanke.

Bei einer positiven Signalflanke am Eingang IN wird der erste n-Kanal Transistor M1 eingeschaltet und der erste p-Kanal Transistor M2 ausgeschaltet. Entsprechend sinkt das Potential am ersten primärseitigen Knotenpunkt a1 transient von einer Spannung nahe der primärseitigen Versorgungsspannung vdd_pri zu einer Spannung nahe Erdpotential gnd_pri ab. Während dieser Spannungsänderung fließt ein Strom IC1 entsprechend der allgemeinen Formel IC = C*dUC /dt über die HV-Kondensatoren C11, C12 von der Sekundärseite zur Primärseite und zieht das Potential am sekundärseitigen Knotenpunkt a2 gemäß der kapazitiven Spannungsteilerregel nach unten, beispielhaft um 400mV (vgl. Fig. 5, Abschnitt I). Gleichzeitig wird durch den zweiten Inverter INV2 eine negative Signalflanke an die zweite Brückenschaltung M3, M4 angelegt, wodurch der zweite n-Kanal Transistor M3 ausgeschaltet und der zweite p-Kanal Transistor M4 eingeschaltet wird. Hierdurch steigt das Potential am zweiten primärseitigen Knotenpunkt b1 transient von einer Spannung nahe Erdpotential gnd_pri zu einer Spannung nahe primärseitigem Versorgungspotential vdd_pri an. Während der Spannungsänderung fließt ein Strom IC3 über die HV-Kondensatoren C31, C32 von der Primärseite zur Sekundärseite und zieht das Potential am sekundärseitigen Knotenpunkt b2 nach oben, beispielhaft um 400mV (vgl. Fig. 5, Abschnitt I). Durch diesen Potentialverriss mit entgegen gesetztem Vorzeichen, ist nun das Potential am sekundärseitigen Knotenpunkt a2 geringer als am sekundärseitigen Knotenpunkt b2, wodurch der Ausgang des Vorwärts-Übertragers OUT_ON den Wert HIGH "Ein" annimmt. Nach dem Ende der Spannungstransienten nähern sich die Potentiale an den sekundärseitigen Knotenpunkten gemäß der ohmsch-kapazitiven Knotenimpedanz exponentiell mit der Zeitkonstante ihrem statischen Wert an (vgl. Fig. 5, Abschnitt II). Die Zeitkonstante des exponentiellen Abklingvorgangs in Abschnitt II Ta2 bzw. Tb2 fasst alle ohmschen und kapazitiven Anteile, die an der Umladung der entsprechenden Knoten a2 bzw. b2 beteiligt sind, zusammen. Solange keine Ausschaltflanke am Eingang IN erscheint, schreitet die Entladung selbständig bis zum statischen Grundzustand fort (vgl. Fig. 5, Abschnitt IV). Sobald der Entladevorgang soweit abgeklungen ist, dass der erste sekundärseitige Knotenpunkt a2 auf einem höheren Potential als der zweite sekundärseitige Knotenpunkt b2 liegt, beispielhaft nach 500ns, schaltet der Ausgang des Übertragungszweigs OUT_ON wieder auf LOW (vgl. Fig.5, Abschnitt III).

Beim Aufbau der Spannung zwischen Primär- und Sekundärseite hat sich an den Knotenpunkten X11, X31 ein Zwischenpotential von 300V eingestellt. Die durch die Schaltsignalflanken an den Knoten a1, b1 verursachten Potentialverschiebungen betragen in der Simulation ca. 5V, sowohl für steigende als auch für fallende Flanken.

Die negative Flanke des Signals am Eingang IN bewirkt kein Ausgangssignal des ON-Übertragungszweigs 82 (vgl. Fig.5, Abschnitt V), vielmehr erzeugt diese ein nicht dargestelltes entsprechendes Signal am OFF-Übertragungszweig 83. Sollte das stationäre Gleichgewicht noch nicht erreicht sein, führt eine negative Signalflanke direkt zu einem LOW-Pegel am Ausgang OUT_ON des ersten Komparators COMP1 (vgl. Fig. 5, Abschnitt VI). Ebenso gilt, dass eine positive Flanke des Signals am Eingang IN immer zu einem HIGH-Pegel am Ausgang OUT_ON des ON-Übertragungszweiges 82 führt, unabhängig davon, ob sich bereits ein stationäres Gleichgewicht an den sekundärseitigen Knotenpunkten a2, b2 eingestellt hat. Jede Flanke am Eingang IN führt somit immer zu einem korrelierenden Schaltzustand am Ausgang OUT_ON, sofern dieser nicht bereits vorliegt. Es lassen sich somit auch Pulsfolgen hoher Frequenz übertragen.

Weitere Simulationen zeigen, dass die Signalübertragung durch Ladungsverschiebung an den HV-Kondensatoren unabhängig davon erfolgt, ob das Bezugspotential gnd_sek der Sekundärseite statisch höher, gleich oder niedriger als das Bezugspotential gnd_pri der Primärseite ist. Bei einem Schaltvorgang der Leistungsschalter, bei dem gleichzeitig oder kurz nacheinander der BOT- Schalter aus bzw. ein- und der TOP-Schalter ein- bzw. ausgeschaltet werden, steigt bzw. sinkt die Spannung am Ausgang der Halbbrücke mit einer schnellen Änderung pro Zeiteinheit (Spannungstransi-enten), von beispielhaft 10kV/μs. In gleichem Maße steigt gleichzeitig das Bezugspotential gnd_sek der Sekundärseite an. Während dieser Phasen ist eine Signalübertragung über die Übertragungszweige 82, 83 und damit über den gesamten Vorwärts-Übertrager 80 nicht möglich und auch nicht erwünscht.

Die Übertragung eines Signals von der Primär- auf die Sekundärseite über einen erfindungsgemäßen Vorwärts-Übertrager kann wie folgt zusammengefasst werden. Bei einer positiven Eingangssignalflanke wird am Ausgang OUT_ON des ON-Übertragungszweig 82 ein positiver Puls bestimmter Länge erzeugt, der von der Signalauswerteschaltung 84 erfasst wird. Daraufhin wird der Ausgang OUT des Vorwärts-Übertragers 80 auf einen Einschaltstatus, beispielhaft HIGH, gesetzt, der auch nach Ende des Signals am Ausgang OUT_ON ansteht. Der Ausgang OUT_OFF des OFF-Übertragungszweigs 83 verharrt auf LOW. Bei einer negativen Eingangssignalflanke wird am Ausgang OUT_OFF des OFF-Übertragungszweigs 83 ein positiver Puls bestimmter Länge erzeugt, der ebenfalls von der Signalauswerteschaltung 84 erfasst wird. Daraufhin wird der Ausgang OUT des Vorwärts-Übertragers 82 zurückgesetzt. Der Ausgang OUT_ON des ON-Übertragungszweigs 82 verharrt auf LOW. Das Signal am Eingang IN wird in vollständiger Länge übertragen und an die TOP-Sekundärseite 40 übergeben. Während hoher Spannungstransienten zwischen primärseitigem gnd_pri und sekundärseitigem Bezugspotential gnd_sek findet keine Signalübertragung statt. Die Ausgänge der Übertragungszweige OUT_ON, OUT_OF) verbleiben im LOW-Zustand bzw. werden auf den LOW-Zustand zurückgesetzt. Der gespeicherte Zustand am Ausgang OUT des Vorwärts-Übertragers 80 bleibt erhalten.

Um eine zur sicheren Detektion ausreichende Pulslänge, beispielhaft 500ns, am Ausgang eines Vorwärts-Übertragers zu erreichen muss die Entladezeitkonstante an den Knoten a2 und b2 groß genug sein. Diese wird bestimmt durch die ohmsche und kapazitive Belastung an den Knoten a2 und b2. Für eine platzsparende monolithische Integration der Schaltung ist der Großteil der benötigten kapazitiven Belastung der Knoten a2 und b2 vorzugsweise durch die Niedervoltkondensatoren C2 und C4 zu realisieren, da sie einen viel geringeren Flächenbedarf pro Kapazitätseinheit gegenüber den HV-Kondensatoren der Schaltung haben. Gleichzeitig soll die kapazitive Kopplung zwischen Primär- und Sekundärseite möglichst gering gehalten werden. Deshalb muss die o.g. Bedingung C1ges/C2 = C3ges/C4 « 1 erfüllt sein. Da herstellungsbedingt nicht alle in Reihe geschalteten Kondensatoren eines Übertragungszweigs den gleichen Kapazitätswert besitzen, ergibt sich zwangsläufig eine ungleichmäßige Spannungsverteilung an den Zwischenpotentialknoten X11 bis X1n-1 bzw. X31 bis X3n-1. Um eine Überschreitung der Spannung über die Spannungsfestigkeit an einem oder mehreren HV-Kondensatoren zu vermeiden ist eine Begrenzung der Spannung über diesen vorzusehen.

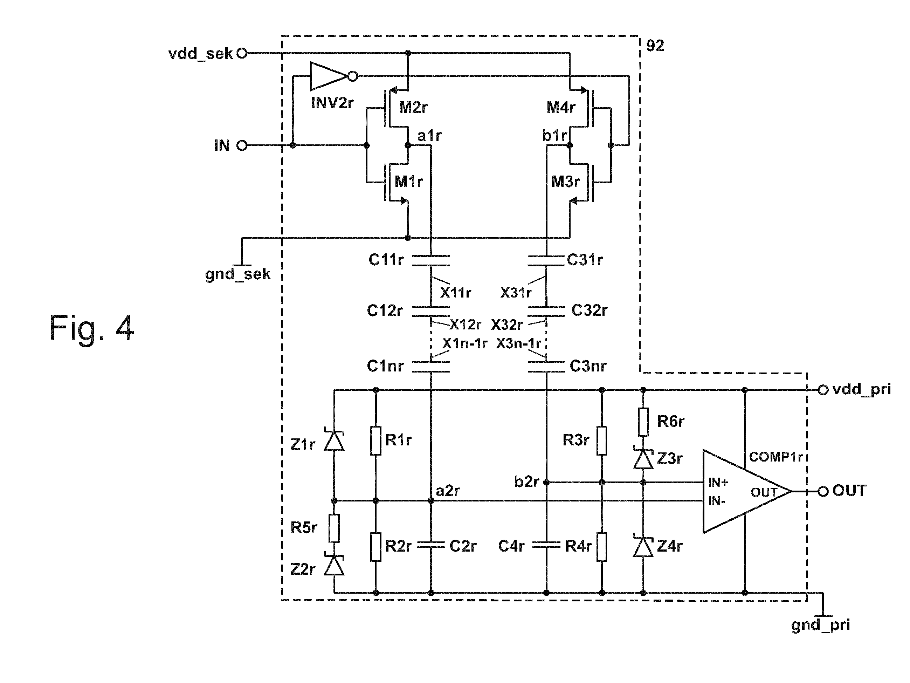

Figur 4 zeigt analog zu Figur 3 die Grundschaltung des erfindungsgemäßen Rückwärts-Übertragers 90, der hier nur als ON-Übertragungszweig 92 ausgebildet ist. Die Bezugszeichen entsprechen denjenigen der Figur 3 mit jeweils angehängtem "r", um die reverse Übertragung zu kennzeichnen.

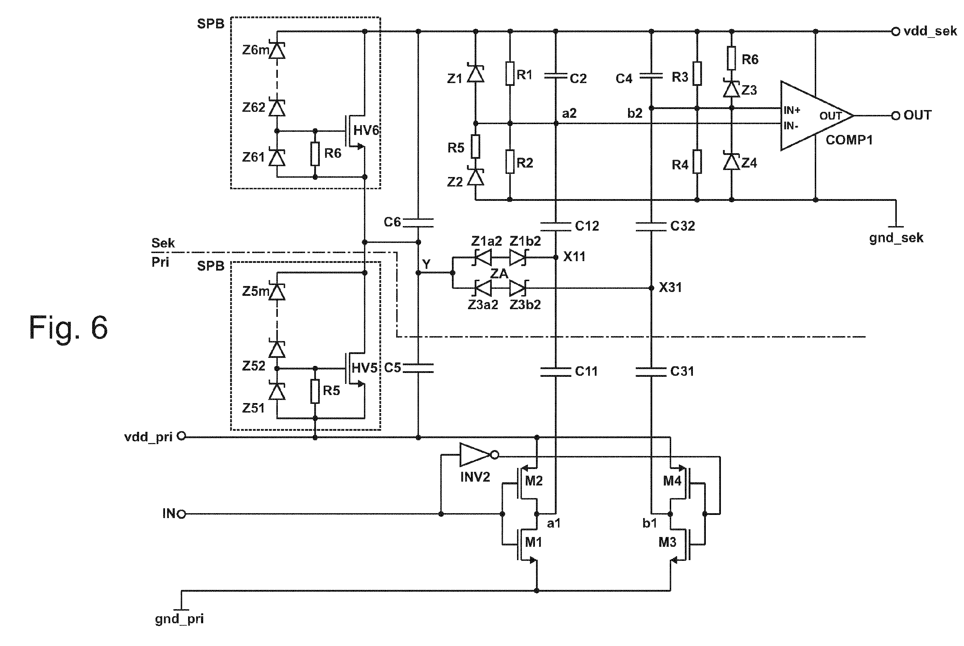

Um die oben genannte Spannungsbegrenzungsschaltung SPB wird die Grundschaltung eines Vorwärts-Übertragerzweigs gemäß Figur 3 in der Ausführungsform nach Figur 6 zusätzlich erweitert. Beispielhaft wird hier n=2 angenommen, d.h. in jedem Übertragungszweig werden zwei HV-Kondensatoren in Reihe geschaltet. Die Zwischenpotentialknoten X11 und X31 sind jeweils über zwei gegenpolig in Reihe geschaltete Zenerdioden am gemeinsamen Knoten Y angebunden, der wiederum den Mittelpunkt eines weiteren kapazitiven Spannungsteilers mit Symmetrierungskondensatoren (C5, C6) zwischen vdd_pri und vdd_sek bildet. Weiterhin beinhaltet die Übertragungsschaltung eine Spannungsbegrenzungsschaltung über jedem HV-Kondensator, beispielhaft in Fig. 6: C5 und C6, wobei hier die obere Spannungsbegrenzungsschaltung mit dem sekundärseitigen Betriebsspannungspotential vdd_sek und dem Knoten Y und die untere Spannungsbegrenzungsschaltung mit dem Knoten Y und dem primärseitigen Betriebsspannungspotential vdd_pri verbunden ist. Die Spannungsbegrenzungsschaltungen sind identisch aufgebaut und bestehen aus einer Zenerdioden-Ausgleichsschaltung ausgebildet als Reihenschaltungen gleichgepolter Zenerdioden der Anzahl y Z5y, Z6y, mit y = 1...m, wobei die Kathoden der jeweils obersten Zenerdiode Z5m, Z6m mit dem oberen Anschluss und die Anode der untersten Zenerdiode Z51, Z61 mit dem unteren Anschluss der Spannungsbegrenzungsschaltung verbunden ist. Parallel zur Reihenschaltung der Zenerdioden ist jeweils ein Spannungsbegrenzungstransistor, ebenfalls ausgebildet als ein Hochvolttransistor, HV5, HV6 geschaltet, wobei das Drain mit dem oberen Anschluss und das Source mit dem unteren Anschluss der jeweiligen Spannungsbegrenzungsschaltung verbunden ist. Vervollständigt wird die Spannungsbegrenzungsschaltung durch einen Widerstand R5, R6, dessen erster Anschluss mit dem Gate des Spannungsbegrenzungstransistors HV5, HV6 und der Kathode der untersten Zenerdiode Z51, Z61 und dessen zweiter Anschluss mit dem unteren Anschluss der Spannungsbegrenzungsschaltung verbunden ist. Das Gate des jeweiligen Spannungsbegrenzungstransistors HV5, HV6 ist einerseits mit der Kathode der ersten Zenerdiode Z51 bzw. Z61 der Reihenschaltung und andererseits über einen Widerstand R5 bzw. R6 mit der Anode der ersten Zenerdiode Z51 bzw. Z61 der Reihenschaltung verbunden.

Die Wirkungsweise der Schaltungserweiterung in der Ausführungsform nach Fig. 6 ist wie folgt. Die HV-Kondensatoren C5 und C6 bilden einen weiteren kapazitiven Spannungsteiler zwischen Primär- und Sekundärseite. Bei gleicher Dimensionierung der HV-Kondensatoren C5 und C6 stellt sich bei zeitlich schneller positiver Spannungsänderung zwischen primärseitigem und sekundärseitigem Bezugspotential die halbe Spannung zwischen Primär- und Sekundärseite am Knoten Y ein. Ist die kapazitive Spannungsteilung in den Übertragungszweigen derart, dass sich an den Knoten X11 bzw. X31 ohne erweiterte Beschaltung ein um mehr als den Betrag einer Zenerspannung der Zenerdioden Z1a2, Z1b2 bzw. Z3a2, Z3b2 unterschiedlicher Spannungswert als an Knoten Y einstellen würde, dann überschreitet die entsprechende Zenerdiode Z1a2 oder Z1b2 bzw. Z3a2 oder Z3b2 ihre Zenerspannung und es fließt ein Ausgleichstrom zwischen den Knoten X11 bzw. X31 und Y über die in Durchbruch befindliche Zenerdiode und die jeweils andere in Durchlass befindliche Zenerdiode. Dieser Ausgleichstrom fließt solange bis sich die Potentiale zwischen X11 bzw. X31 und Y soweit angenähert haben, dass die Zenerdioden-Kette Z1a2, Z1b2 bzw. Z3a2, Z3b2 wieder sperrt. Ist die kapazitive Belastung am Knoten Y sehr viel größer als an den Knoten X11 bzw. X31, d.h. C5 +C6 »C11 + C12 bzw. C31 + C32, dann ändern sich während des Ausgleichsvorgangs überwiegend die Potentiale an X11 bzw. X31. Die Spannungsbegrenzungsschaltungen begrenzen das Potential am Knoten Y gegenüber vdd_pri (untere Schaltung) und vdd_sek (obere Schaltung). Wird während eines Ausgleichsvorgangs die Spannung an einem der HV-Kondensatoren C5 oder C6 so groß, dass die Begrenzungsspannung Uclamp der y in Reihe geschalteten Zenerdioden Uclamp = y*Uz überschritten wird, dann beginnt ein Querstrom durch die niederohmig gewordene Zenerdioden-Kette zu fließen, der einen Abbau der Überspannung bewirkt. Ein Teil des Stroms fließt durch den Widerstand R5 bzw. R6. Überschreitet der Spannungsabfall über R5 bzw. R6 die Schwellspannung von HV5 bzw. HV6, dann öffnet dieser. Über der Drain-Source-Strecke von HV5 bzw. HV6 entsteht ein zusätzlicher niederohmiger Querstrompfad. Der Knoten Y kann somit einfacher festgehalten bzw. mit hohen Strömen schnell umgeladen werden. Auf diese Weise wird die Spannung am Knoten Y und indirekt über Z1a2, Z1b2 bzw. Z3a2, Z3b2 auch an den Knoten X11 und X31 begrenzt. Die Begrenzungsspannung Uclamp der y in Reihe geschalteten Zenerdioden der jeweiligen Spannungsbegrenzungsschaltung muss dabei kleiner sein als die zulässigen Spannungen an den HV-Kondensatoren C5 und C6, C11 und C12, C31 und C32 und den Spannungsbegrenzungstransistoren HV5 und HV6.

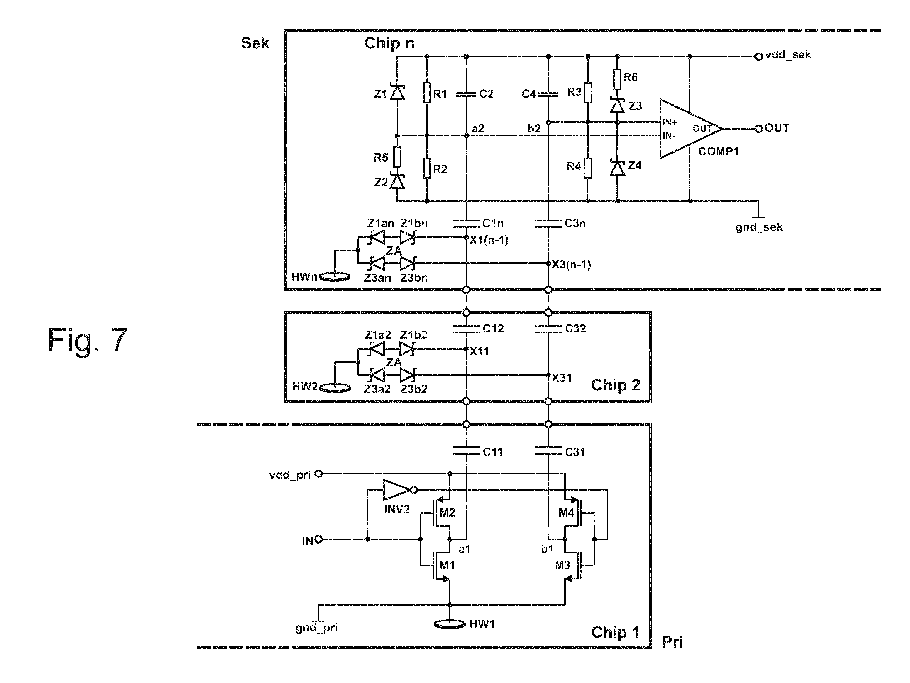

Fig. 7 stellt eine weitere Ausführungsform des erfindungsgemäßen Übertragers dar, mit der es möglich ist Signale über eine hohe Potentialbarriere zu übertragen, die größer ist als die Spannungsfestigkeit in einer einzelnen monolithisch integrierten Schaltung. Die jeweilige Spannungsfestigkeit wird zum einen bestimmt durch die Durchbruchspannung der integrierten Übertragungsschaltungen, die bei herkömmlichen Topologien von der Durchbruchspannung des eingesetzten Hochspannungsbauelements (integrierter Hochvolttransistor) bestimmt wird, und zum anderen durch die Spannungsfestigkeit der Isolation zwischen Primärseite und Sekundärseite. Die Spannungsfestigkeit der Isolation wird von der Halbleitertechnologie bestimmt und kann mit schaltungstechnischen Maßnahmen nicht erhöht werden. Dagegen kann die Spannungsfestigkeit der Übertragungsschaltung, wie oben beschrieben, durch die Verwendung von n Hochspannungsbauelementen in Reihe in einem Multi-Chip-Modul auf den n-fachen Wert erhöht werden.

Da in den meisten Fällen die Durchbruchspannungen der Isolation und der verfügbaren Hochspannungsbauelemente annähernd gleich groß sind, kann die Spannungsfestigkeit der gesamten Übertragungsschaltung nur auf den n-fachen Wert erhöht werden, wenn jeder der n Hochspannungsbauelemente auf einem separaten Substrat integriert wird. Somit können mit 600V-Isolationsverfahren nach dem Stand der Technik höhere Potentialdifferenzen überwunden werden. Werden beispielsweise zwei Chips eingesetzt kann eine integrierte Schaltungsanordnung auch für die Spannungsklasse von 1200V realisiert werden, bei drei Chips bis 1800V und analog für weitere Spannungsklassen.

Die Ausführungsform des Vorwärts-Übertragers in dieser Ausführungsform unterscheidet sich von derjenigen gemäß Fig. 3, dass der Übertrager auf n separate Chips aufgeteilt ist, wobei auf jedem Chip einer der n HV-Kondensatoren C11 bis C1n bzw. C31 bis C3n integriert wird. Auf Chip 1 sind die HV-Kondensatoren C11 und C31, die Transistoren M1 bis M4, sowie der Inverter INV2 integriert. Gegebenenfalls können auf Chip 1 weitere Schaltungen wie z.B. eine Logikbaugruppe sowie ein Treiber für einen BOT-Schalter integriert werden. Der Rückseitenkontakt, handle wafer, HW1 des ersten Chips 1 ist mit dem primärseitigem Bezugspotential gnd_pri verbunden. Die Chips 2 bis n-1 enthalten jeweils zwei HV-Kondensatoren, einen für jeden Übertragungszweig, die wie in der ersten und zweiten Ausführungsform jeweils mit den HV-Kondensatoren C11 bis C1n bzw. C31 bis C3n verbunden sind, sowie die Zenerdioden Z1ax und Z1bx bzw. Z3ax und Z3bx, mit x=2..n-1, des jeweiligen Chips, deren einer Anschluss mit dem Knoten X1 x-1 bzw. X3x-1 und der jeweils andere Anschluss mit dem Rückseitenkontakt HWx, mit x=2..n-1, des jeweiligen Chips verbunden ist. Der Chip n enthält in jedem Fall die HV-Kondensatoren C1n und C3n, die Zenerdioden Z1an, Z1bn, Z3an, Z3bn,die Kondensatoren C2 und C4, die Widerstände R1 bis R6, die Zenerdioden Z1 bis Z4 sowie den Komparator COMP1.

Der Rückseitenkontakt HWn des Chips n ist mit dem jeweils einen Anschluss der Zenerdioden Z1an bzw. Z3an verbunden.

Die Signalübertragung bei der Ausführungsform des Vorwärts-Übertragers nach Fig. 6 erfolgt mit dem erfindungsgemäßen Übertragungsverfahren in analoger Weise wie bei den vorherigen Ausführungsformen nach Fig. 3 und 5. Die jeweils gegenpolig in Reihe geschalteten Zenerdioden Z1ax und Z1bx bzw. Z3ax und Z3bx binden den Rückseitenkontakt HWx der jeweiligen Chips an die jeweiligen Zwischenpotentialknoten X1x-1 bzw. X3x-1, mit x=2..n-1, der jeweiligen Chips an.

**Patentansprüche**

1. Ansteuerschaltung mit Übertragungsschaltung zur Übertragung eines Signals über eine Potentialbarriere hinweg, von einer ersten Potentialseite (Pri, Sek) mit erstem Grundpotential zu einer zweiten Potentialseite (Sek, Pri) mit zweitem Grundpotential, mit einer kapazitiv wirkenden Übertragungseinrichtung (80,90) mit kapazitiver Kopplung zwischen der ersten und der zweiten Potentialseite, wobei
   die Übertragungseinrichtung (80,90) genau einen oder zwei Zweige, somit nur einen ON- Übertragungszweig (82, 92) oder einen ON- Übertragungszweig (82) und einen OFF- Übertragungszweig (83) aufweist, die ihrerseits jeweils einen ersten und einen zweiten Teilzweig aufweisen, **dadurch gekennzeichnet, dass** die kapazitive Kopplung zwischen erster und zweiter Potentialseite bei jedem Teilzweig durch eine Reihenschaltung einer Mehrzahl von ersten und zweiten Hochvoltkondensatoren (C1 x, C3x, mit x = 1...n bzw. x = 1 r...nr) ausgebildet ist, die wiederum jeweils eine Reihenschaltung mit einem zugeordneten Kondensator (C2, C4 bzw. C2r, C4r) auf der zweiten Potentialseite bilden, wobei innerhalb des jeweiligen Übertragungszweiges (82, 83, 92) das Signal direkt an dem ersten Teilzweig und über einen zweiten Inverter (INV2, INV2r) an dem zweiten Teilzweig anliegt und
   wobei bei zwei Zweigen ein Signal (IN) am Eingang direkt an dem ON-Übertragungszweig (82) und über einen ersten Inverter (INV1) am OFF-Übertragungszweig (83) anliegt und wobei
   parallel zu den ersten und zweiten Hochvoltkondensatoren (C1 x, C3x) eines Zweiges ein weiterer kapazitiver Spannungsteiler mit der gleichen Anzahl von Symmetrierungskondensatoren (C5, C6) wie erste und zweite Hochvoltkondensatoren (C1 x, C3x) angeordnet ist, wobei jedes der Zwischenpotentiale (X1 x, X3x) von Symmetrierungs- (C5, C6) und zugeordneten Hochvoltkondensatoren (C1 x, C3x) mittels einer Zenerdioden-Ausgleichsschaltung (ZA) verbunden sind.

2. Ansteuerschaltung nach Anspruch 1, wobei
   die Zenerdioden-Ausgleichsschaltung (ZA) ausgebildet ist als je zwei Reichenschaltungen zweier Zenerdioden (Z1ax, Z1bx bzw. Z3ax, Z3bx, mit x=2..n), die mit Ihren Anoden oder Kathoden miteinander verbunden sind und deren Kathoden bzw. Anoden mit dem jeweiligen Zwischenpotential (Y) der Symmetrierungskondensatoren (C5, C6) und dem zugeordneten Zwischenpotential (X1x, X3x) der Hochvoltkondensatoren (C1x, C3x) verbunden sind.

3. Ansteuerschaltung nach Anspruch, wobei
   die Reihenschaltung der Symmetrierungskondensatoren (C5, C6) also der weitere kapazitive Spannungsteiler mit dem Versorgungspotentialen (vdd_sek, vdd_prim) der ersten und zweiten Potentialseite (Pri, Sek) verbunden sind.

4. Ansteuerschaltung nach Anspruch, wobei
   zu jedem Symmetrierungskondensator (C5, C6) des weiterern kapazitiven Spannungsteilers eine Spannungsbegrenzungsschaltung (SPB) parallel geschaltet ist.

5. Ansteuerschaltung nach Anspruch 4, wobei
die Spannungsbegrenzungsschaltung (SPB) mit einem oberen und einem unteren Anschluss, aus einer Reihenschaltung von weiteren Zenerdioden (Z5y, Z6y mit y = 1...m) und einem parallel geschalteten Spannungsbegrenzungstransistor (HV5, HV6) besteht, dessen Source mit dem unteren Anschluss, dessen Drain mit dem oberen Anschluss der Spannungsbegrenzungsschaltung (SPB) und dessen Gate einerseits mit der Kathode der ersten Zenerdiode (Z51, Z61) der Reihenschaltung und andererseits über einen Widerstand mit der Anode der ersten Zenerdiode der Reihenschaltung verbunden ist.

6. Ansteuerschaltung nach einem der vorhergehenden Ansprüche, wobei die jeweiligen Komponenten auf einer Mehrzahl von voneinander elektrisch isolierten Substraten (Chip 1 ... Chip n) monolithisch integriert angeordnet sind.

7. Ansteuerschaltung nach Anspruch 6, wobei
die jeweiligen Komponenten auf zwei Substraten (Chip 1, Chip n mit n=2) angeordnet sind und hierbei die Komponenten der ersten Potentialseite auf dem ersten Substrat angeordnet sind und diejenigen der zweiten Potentialseite auf dem zweiten Substrat angeordnet sind.

8. Ansteuerschaltung nach Anspruch 6, wobei
die jeweiligen Komponenten auf mehr als zwei Substraten (Chip x mit x = 1...n) angeordnet sind und hierbei die Komponenten der ersten Potentialseite auf einem ersten Substrat angeordnet sind und diejenigen der zweiten Potentialseite auf einem zweiten Substrat angeordnet sind, sowie Hochvoltkondensatoren und zugeordnete Spannungsbegrenzungsschaltungen auf jeweils eigenen weiteren Substraten (Chip 2 ... Chip n-1) angeordnet sind.

9. Ansteuerschaltung nach einem der Ansprüche 7 oder 8, wobei
die jeweiligen Substrate (Chip 1 ... Chip n) innerhalb eines Multi-Chip-Moduls angeordnet sind.

10. Verfahren zum Betrieb einer Ansteuerschaltung nach Anspruch 1-9, wobei auf einer ersten Potentialseite ein Eingangssignal am Eingang (IN) der Übertragungseinrichtung (80, 90) direkt an einen ON- Übertragungszweig (82, 92) angelegt wird, **dadurch gekennzeichnet, dass** in jedem Übertragungszweig (82, 92) das dortige Signal einen Stromfluss durch erste Hochvoltkondensatoren (C1 x, C1 xr) eines ersten Teilzweiges und einen inversen Stromfluss durch zweite Hochvoltkondensatoren (C3x, C3xr) eines zweiten Teilzweiges erzeugt, dieser jeweilige Stromfluss auf der zweiten Potentialseite detektiert und einer beiden Teilzweigen gemeinsamen Auswerteschaltung (84, 94) zugeführt wird, die das Eingangssignal (IN) der ersten Potentialseite auf der zweiten Potentialseite rekonstruiert (OUT) und wobei eine Spannungsbegrenzungsschaltung (SPB) in Kombination mit einer Zenerdioden-Ausgleichsschaltung (ZA) die über den jeweiligen Hochvoltkondensatoren (X1 x, X3x, X1 xr, X3xr) abfallende Teilspannung begrenzt.

11. Verfahren zum Betrieb einer Ansteuerschaltung nach Anspruch 10, wobei ein Eingangssignal am Eingang (IN) der Übertragungseinrichtung (80, 90) direkt an einen ON- Übertragungszweig (82, 92) und invertiert an einen OFF-Übertragungszweig (83) angelegt wird.

**Claims**

1. Drive circuit with a transmission circuit for transmitting a signal across a potential barrier, from a first potential side (Pri, Sek) having a first earth potential to a second potential side (Sek, Pri) having a second earth potential, with a capacitively acting transmission device (80, 90) having capacitive coupling between the first and second potential sides, wherein the transmission device (80, 90) has exactly one or two branches, thus only an ON transmission branch (82, 92) or an ON transmission branch (82) and an OFF transmission branch (83), which for their part each have a first and a second partial branch, **characterized in that** the capacitive coupling between the first and second potential sides is formed in each partial branch by means of a series circuit comprising a plurality of first and second high-voltage capacitors (C1x, C3x, where x = 1...n or x = 1r....nr), which in turn each form a series circuit with an assigned capacitor (C2, C4 or C2r, C4r) on the second potential side, wherein, within the respective transmission branch (82, 83, 92) the signal is present directly at the first partial branch and is present at the second partial branch via a second inverter (INV2, INV2r), and
wherein, in the case of two branches, a signal (IN) at the input is present directly at the ON transmission branch (82) and is present at the OFF transmission branch (83) via a first inverter (INV1) and wherein

a further capacitive voltage divider having the same number of balancing capacitors (C5, C6) as first and second high-voltage capacitors (C1x, C3x) is arranged in parallel with the first and second high-voltage capacitors (C1x, C3x) of a branch, wherein each of the intermediate potentials (X1x, X3x) of balancing capacitors (C5, C6) and assigned high-voltage capacitors (C1x, C3x) are connected by means of a zener diode compensation circuit (ZA).

2. Drive circuit according to Claim 1, wherein
the zener diode compensation circuit (ZA) is embodied as two respective series circuits comprising two zener diodes (Z1ax, Z1bx and Z3ax, Z3bx, where x = 2...n) which are connected to one another by their anodes or cathodes and the cathodes or anodes of which are connected to the respective intermediate potential (Y) of the balancing capacitors (C5, C6) and the assigned intermediate potential (X1x, X3x) of the high-voltage capacitors (C1x, C3x).

3. Drive circuit according to Claim, wherein
the series circuit comprising the balancing capacitors (C5, C6), that is to say the further capacitive voltage divider, is connected to the supply potentials (vdd_sek, vdd_prim) of the first and second potential sides (Pri, Sek).

4. Drive circuit according to Claim, wherein
a voltage limiting circuit (SPB) is connected in parallel with each balancing capacitor (C5, C6) of the further capacitive voltage divider.

5. Drive circuit according to Claim 4, wherein
the voltage limiting circuit (SPB) having an upper and a lower connection consists of a series circuit comprising further zener diodes (Z5y, Z6y where y = 1... m) and a parallel-connected voltage limiting transistor (HV5, HV6), the source of which is connected to the lower connection, the drain of which is connected to the upper connection of the voltage limiting circuit (SPB) and the gate of which is connected firstly to the cathode of the first zener diode (Z51, Z61) of the series circuit and secondly via a resistor to the anode of the first zener diode of the series circuit.

6. Drive circuit according to any of the preceding claims, wherein
the respective components are arranged in a monolithically integrated manner on a plurality of mutually electrically insulated substrates (Chip 1 ... Chip n).

7. Drive circuit according to Claim 6, wherein
the respective components are arranged on two substrates (Chip 1, Chip n where n = 2) and in this case the components of the first potential side are arranged on the first substrate and those of the second potential side are arranged on the second substrate.

8. Drive circuit according to Claim 6, wherein
the respective components are arranged on more than two substrates (Chip x where x = 1...n) and in this case the components of the first potential side are arranged on a first substrate and those of the second potential side are arranged on a second substrate, and high-voltage capacitors and assigned voltage limiting circuits are arranged on respectively dedicated further substrates (Chip 2 ... Chip n-1).

9. Drive circuit according to any of Claims 7 or 8, wherein
the respective substrates (Chip 1 ... Chip n) are arranged within a multi-chip module.

10. Method for operating a drive circuit according to Claims 1-9, wherein, on a first potential side, an input signal at the input (IN) of the transmission device (80, 90) is applied directly to an ON transmission branch (82, 92), **characterized in that** in each transmission branch (82, 92) the signal there generates a current flow through first high-voltage capacitors (C1x, C1xr) of a first partial branch and an inverse current flow through second high-voltage capacitors (C3x, C3xr) of a second partial branch, this respective current flow is detected on the second potential side and is fed to an evaluation circuit (84, 94) which is common to both partial branches and reconstructs the input signal (IN) of the first potential side on the second potential side (OUT), and wherein a voltage limiting circuit (SPB) in combination with a zener diode compensation circuit (ZA) limits the partial voltage dropped across the respective high-voltage capacitors (X1x, X3x, X1xr, X3xr).

11. Method for operating a drive circuit according to Claim 10, wherein
an input signal at the input (IN) of the transmission device (80, 90) is applied directly to an ON transmission branch (82, 92) and is applied to an OFF transmission branch (83) in an inverted manner.

**Revendications**

1. Circuit de commande doté d'un circuit de transmission qui transmet par l'intermédiaire d'une barrière de potentiel un signal depuis le côté d'un premier potentiel (Pri, Sek) présentant un premier potentiel de base vers le côté d'un deuxième potentiel (Sek, Pri) présentant un deuxième potentiel de base, avec un dispositif de transmission (80, 90) travaillant par voie capacitive et couplage capacitif entre le côté du premier potentiel et le côté du deuxième potentiel, le dispositif de transmission (80, 90) présentant exactement une ou deux branches, à savoir uniquement une branche de transfert ON (82, 92) ou une branche de transfert ON (82) et une branche de transmission OFF (83) qui elle-même présente une première et une deuxième branche partielle,

   **caractérisé en ce que**

   le couplage capacitif entre le côté du premier potentiel et le côté du deuxième potentiel pour chaque branche partielle est formé par le raccordement en série de plusieurs premiers et deuxièmes condensateurs (C1x, C3x, avec x = 1...n ou x = 1r...nr) à haute tension qui eux-mêmes forment un circuit série avec un condensateur (C2, C4 ou C2r, C4r) associé situé sur le côté au deuxième potentiel,

   **en ce que** le signal est appliqué à l'intérieur de chaque branche de transmission (82, 83, 92) directement sur la première branche partielle et par l'intermédiaire d'un deuxième inverseur (INV2, INV2r) sur la deuxième branche partielle et

   dans le cas de deux branches, un signal (IN) est appliqué directement sur l'entrée de la branche de transmission ON (82) et par l'intermédiaire d'un premier inverseur (INV1) sur la branche de transmission OFF (83),

   **en ce qu'**un autre diviseur de tension capacitif présentant le même nombre de condensateurs de symétrisation (C5, C6) que les premiers et les deuxièmes condensateurs (C1x, C3x) à haute tension est disposé parallèlement aux premiers et aux deuxièmes condensateurs (C1x, C3x) à haute tension d'une branche et

   **en ce que** chacun des potentiels intermédiaires (X1x, X3x) des condensateurs de symétrisation (C5, C6) et des condensateurs (C1x, C3x) à haute tension associés est raccordé au moyen d'un circuit d'équilibrage (ZA) à diodes Zener.

2. Circuit de commande selon la revendication 1, dans lequel le circuit d'équilibrage (ZA) à diodes Zener est configuré comme deux circuits série constitués de deux diodes Zener (Z1ax, Z1bx ou Z3ax, Z3bx, avec x = 2 ... n) dont les anodes ou cathodes sont raccordées les unes aux autres et dont les cathodes ou anodes sont raccordées au potentiel intermédiaire (Y) correspondant des condensateurs de symétrisation (C5, C6) et au potentiel intermédiaire (X1x, X3x) associé des condensateurs (C1x, C3x) à haute tension.

3. Circuit de commande selon la revendication, dans lequel le circuit série des condensateurs de symétrisation (C5, C6) et l'autre diviseur de tension capacitif sont raccordés aux potentiels d'alimentation (vdd_sek, vdd_prim) du côté au premier potentiel et du côté au deuxième potentiel (Pri, Sek).

4. Circuit de commande selon la revendication, dans lequel un circuit (SPB) de limitation de tension est raccordé en parallèle à chaque condensateur de symétrisation (C5, C6) de l'autre diviseur de tension capacitif.

5. Circuit de commande selon la revendication 4, dans lequel le circuit (SPB) de limitation de tension est raccordé à une borne supérieure et une borne inférieure, est constitué du circuit série d'autres diodes Zener (Z5y, Z6y avec y = 1 ... m) et d'un transistor (HV5, HV6) de limitation de tension raccordé en parallèle dont la source est raccordée à la borne inférieure, le drain à la borne supérieure du circuit (SPB) de limitation de tension et la grille d'une part à la cathode de la première diode Zener (Z51, Z61) du circuit série et d'autre part, par l'intermédiaire d'une résistance, à l'anode de la première diode Zener du circuit série.

6. Circuit de commande selon l'une des revendications précédentes, dans lequel chaque composant est intégré monolithiquement sur plusieurs substrats (Puce 1... Puce n) isolés électriquement les uns des autres.

7. Circuit de commande selon la revendication 6, dans lequel chaque composant est disposé sur deux substrats (Puce 1, Puce n, avec n = 2) et ainsi les composants du côté du premier potentiel sont disposés sur le premier substrat et ceux du côté du deuxième potentiel sur le deuxième substrat.

8. Circuit de commande selon la revendication 6, dans lequel les différents composants sont disposés sur plus de deux substrats (Puce x avec x = 1 ... n), les composants du côté au premier potentiel étant disposés sur un premier substrat et ceux du côté au deuxième potentiel sur un deuxième substrat, des condensateurs à haute tension et des circuits de limitation de tension associés étant disposés chacun sur leur propre autre substrat (Puce 2, ..., Puce n-1).

9. Circuit de commande selon l'une des revendications 7 ou 8, dans lequel les différents substrats (Puce 1, ..., Puce n) sont disposés à l'intérieur d'un module multipuce.

10. Procédé de conduite d'un circuit de commande selon les revendications 1 à 9, dans lequel du côté d'un premier potentiel un signal d'entrée à l'entrée (IN) du dispositif de transmission (80, 90) est appliqué directement sur une branche de transmission ON (82, 92),

    **caractérisé en ce que**

    dans chaque branche de transmission (82, 92), le signal forme un écoulement de courant traversant des premiers condensateurs (C1x, C1xr) à haute tension d'une première branche partielle et un écoulement de courant opposé dans les deuxièmes condensateurs (C3x, C3xr) à haute tension d'une deuxième branche partielle,

    **en ce que** chacun de ces écoulements de courant est détecté du côté du deuxième potentiel et est amené à un circuit d'évaluation (84, 94) commun aux deux branches partielles qui reconstruit (OUT) sur le côté du deuxième potentiel le signal d'entrée (IN) du côté du premier potentiel et

    **en ce qu'**un circuit (SPB) de limitation de tension limite la tension partielle aux bornes des condensateurs (X1x, X3x, X1xr, X3xr) respectifs à haute tension en combinaison avec un circuit d'équilibrage (ZA) à diodes Zener.

11. Procédé de conduite d'un circuit de commande selon la revendication 10, dans lequel un signal d'entrée présent à l'entrée (IN) du dispositif de transmission (80, 90) est appliqué directement sur une branche de transmission ON (82, 92) et après inversion sur une branche de transmission OFF (83).

Fig. 1

Fig. 2

EP 2 731 269 B1

Fig. 3

Fig. 4

Fig. 5

Fig. 6

Fig. 7

18

**EP 2 731 269 B1**

**IN DER BESCHREIBUNG AUFGEFÜHRTE DOKUMENTE**

**In der Beschreibung aufgeführte Patentdokumente**

- DE 102010018997 A1